(19) **Europäisches Patentamt European Patent Office Office européen des brevets**

(11) **EP 1 446 517 B1**

(12) **EUROPEAN PATENT SPECIFICATION**

(45) Date of publication and mention of the grant of the patent:
**27.06.2007 Bulletin 2007/26**

(51) Int Cl.:
***C30B 15/02*** (2006.01)

(21) Application number: **02789582.0**

(86) International application number:
**PCT/US2002/036169**

(22) Date of filing: **12.11.2002**

(87) International publication number:
**WO 2003/044249 (30.05.2003 Gazette 2003/22)**

(54) **INTERMITTENT FEEDING TECHNIQUE FOR INCREASING THE MELTING RATE OF POLYCRYSTALLINE SILICON**

VERFAHREN ZUR SCHRITTWEISEN ZUFÜHRUNG VON SILIZIUM UM DIE ABSCHMELZRATE VON POLYKRISTALLINEM SILIZIUM ZU ERHÖHEN

TECHNIQUE D'ALIMENTATION INTERMITTENTE POUR ACCROITRE LE DEBIT DE FUSION DE SILICIUM POLYCRISTALLIN

(84) Designated Contracting States:
**DE FR GB IT**

(30) Priority: **15.11.2001 US 2862**

(43) Date of publication of application:
**18.08.2004 Bulletin 2004/34**

(60) Divisional application:
**07104628.8**

(73) Proprietor: **MEMC Electronic Materials, Inc.
St. Peters,
Missouri 63376 (US)**

(72) Inventor: **HOLDER, John, D.
Lake St. Louis, MO 63367 (US)**

(74) Representative: **Smaggasgale, Gillian Helen et al
W.P. Thompson & Co,
55 Drury Lane
London WC2B 5SQ (GB)**

(56) References cited:
**WO-A-00/42243**        **WO-A-99/20815**
**US-A- 5 037 503**      **US-A- 5 059 410**
**US-A- 5 588 993**

**Description**

BACKGROUND

The present invention generally relates to the production of single crystal silicon, and specifically, to a process for feeding granular polycrystalline silicon while preparing a silicon melt.

Most single crystal silicon used for microelectronic circuit fabrication is prepared by the Czochralski (CZ) process. In this process, a single crystal silicon ingot is produced by melting polycrystalline silicon in a crucible, dipping a seed crystal into the silicon melt, withdrawing the seed crystal in a manner sufficient to achieve the diameter desired for the ingot and growing the single crystal at that diameter. The polycrystalline silicon melted to form the silicon melt is typically irregularly shaped chunk polycrystalline silicon prepared by the Siemens process or, alternatively, free-flowing, generally spherically-shaped granular polycrystalline silicon, typically prepared by a fluidized-bed reaction process. The preparation and characteristics of chunk and granular polycrystalline silicon are detailed in F. Shimura, Semiconductor Silicon Crystal Technology, pages 116-121, Academic Press (San Diego CA, 1989) and the references cited therein.

The initial charging of chunk type polycrystalline silicon into the crucible and the melting thereof can introduce undesirable impurities and defects into the single crystal silicon ingot. For example, when a crucible is initially charged entirely with chunk polycrystalline silicon, the edges of the chunks under the load of a full charge can scratch and gouge the crucible wall, resulting in a damaged crucible and in particles of crucible floating on or being suspended in the silicon melt. These impurities significantly increase the likelihood of dislocations forming within the single crystal, and decrease the dislocation-free single crystal production yields and throughput. Careful arrangement of the chunk polycrystalline silicon during the initial loading can minimize the thermal stresses. As melting proceeds, however, the charge can shift or the lower portion of the chunk polycrystalline silicon can melt away and leave either a "hanger" of unmelted material stuck to the crucible wall above the melt or a "bridge" of unmelted material bridging between opposing sides of the crucible wall over the melt. When the charge shifts or a hanger or bridge collapses, it may splatter molten silicon and/or cause mechanical stress damage to the crucible. Additionally, initial loadings of 100% chunk polycrystalline silicon limit the volume of material which can be charged due to the poor packing densities of such chunk materials. The volume limitations directly impact single crystal throughput.

Problems also exist when a CZ crucible is initially charged entirely with granular polycrystalline silicon. Large amounts of power are required to melt the granular polycrystalline due to its low thermal conductivity. The thermal stress induced in the crucible by exposure to such high meltdown-power can cause distortion of the crucible and particles of the crucible to be loosened and suspended in the melt. Like the mechanical stresses, these thermal stresses result in reduced zero-defect crystal production yields and throughput. Thus, to avoid the thermal stresses, loadings of 100% granular polycrystalline silicon are typically of a smaller size which reduces overall throughput.

Whether the crucible is initially loaded with chunk or granular polycrystalline silicon, in many processes it is desired to add polycrystalline silicon to the melt with a feeding/metering system to increase the quantity of molten silicon. The use of such additional loadings of charge-up polycrystalline silicon is known for batch, semi-continuous or continuous process systems. In the batch system, for example, additional silicon may be loaded into the existing melt to achieve full crucible capacity in light of the decrease in volume after the initial polycrystalline silicon charge is melted. Japanese Utility Model Application No. 50-11788 (1975) is exemplary. In semi-continuous and continuous CZ systems, additional polycrystalline silicon is charged to the silicon melt to replenish the silicon withdrawn as the single crystal. F. Shimura, Semiconductor Silicon Crystal Technology, p. 175-83, Academic Press (San Diego CA, 1989).

Although granular polycrystalline silicon is generally the material of choice to replenish batch, semi-continuous and continuous CZ systems because of its free-flowing form, it is not without its disadvantages. As disclosed by Kajimoto et al. in U.S. Patent No. 5,037,503, granular polycrystalline silicon prepared by the silane process contains hydrogen in an amount sufficient to cause the silicon granules to burst or explode when they are immersed in molten silicon. The explosion or bursting of the polycrystalline silicon granules causes scattered silicon droplets to accumulate on the surface of the crucible and other components in the crystal puller which can fall into the molten silicon and interrupt crystal growth. As a solution to this problem, Kajimoto et al. suggest reducing the hydrogen content of the granular polycrystalline silicon by preheating the granular polycrystalline in an inert gas atmosphere in a separate heating apparatus until the concentration of $H_2$ is 7.5 ppm by wt. (210 ppma) or less. While this approach tends to reduce the force with which the granules explode, it does not eliminate the phenomena. Rather, the bursting phenomena can still be experienced with granular polycrystalline having a hydrogen concentration of less than 1 ppm by wt. (28 ppma). To date, granular polycrystalline silicon is available in commercial quantities having a hydrogen concentration ranging from about 0.4 to about 0.7 ppm by wt. (11-20 ppma).

An alternative solution to this problem is disclosed by Holder in U.S. Patent No. 5,588,993, wherein chunk polycrystalline silicon is partially melted and then granular polycrystalline silicon is continuously fed onto the exposed unmelted portion of the chunk polycrystalline silicon (column 4, line 66 to column 5, line 4). The granular polycrystalline silicon is fed at a rate which allows for it to reach a temperature greater than about 1200 °C and remain at this temperature for about 30 seconds before melting. Heating the granular polycrystalline silicon in this manner allows for it to be dehydrogenated before becoming immersed in the silicon melt. A less than desirable characteristic with such an approach is that the continuous feeding of granular polycrystalline silicon is limited to a relatively slow rate (e.g., about 8-12 kg/hr) which extends the feeding time and thereby increases the time required to prepare the silicon melt. For example, the time typically required to prepare a 80 kg silicon melt is about 7-8 hours, thus acting to reduce the crystal puller throughput, especially as the average hydrogen content of the granular polycrystalline silicon feed exceeds about 10 ppma. For a 100 and a 120 kg silicon melt, the typical melt down time is about 10 and 12 hours, respectively. This relatively slow feed rate is due, in large part, to the crucible limitations discussed above. Specifically, the power necessary to increase the melt down rate of the granular polycrystalline silicon would distort the crucible and result in crucible particles being suspended in the melt.

As a result, a need continues to exist for a process whereby polycrystalline silicon can be melted more quickly to form silicon melts while maintaining the yield of dislocation-free single crystal silicon ingots produced from these melts.

SUMMARY OF THE INVENTION

Among the objects of the present invention, therefore, is the provision of a process whereby polycrystalline silicon can be melted more quickly to form silicon melts; the provision of a polycrystalline feed and melt process which maintains a yield of dislocation-free single crystal silicon ingots produced from these melts; the provision of feed process which allows for fed granular polycrystalline silicon to be dehydrogenated before becoming immersed in the silicon melt; and the provision of a process whereby the location onto which polycrystalline silicon is fed is controlled.

Briefly, therefore, the present invention is directed to process for preparing a silicon melt in a crucible for use in growing a single crystal silicon ingot by the Czochralski method. The process comprises forming a partially melted charge in the crucible, the partially melted charge comprising molten silicon and unmelted polycrystalline silicon, the molten silicon having an upper surface, the unmelted polycrystalline silicon comprising an exposed portion that is above the upper surface of the molten silicon. The process further comprises rotating the crucible and feeding polycrystalline silicon into the rotating crucible by intermittently delivering the fed polycrystalline silicon onto the exposed unmelted polycrystalline silicon. The intermittent delivery comprises a plurality of alternating on-periods and off-periods, wherein each on-period comprises flowing the fed polycrystalline silicon through a feed device that directs the flow of the fed polycrystalline silicon onto the unmelted polycrystalline silicon for an on-duration, and each off-period comprises interrupting the flow of the fed polycrystalline silicon for an off-duration. The process further comprises melting the unmelted polycrystalline silicon and the fed polycrystalline silicon to form the silicon melt.

Preferably, the process for preparing a silicon melt in a crucible further comprises forming the partially melted charge by loading the crucible with polycrystalline silicon and heating the loaded polycrystalline silicon to form molten silicon and unmelted polycrystalline silicon.

Preferably the crucible comprises an interior wall and has an inner diameter ($D$) and the loaded crucible is rotated at a rate ($r$).

The exposed unmelted polycrystalline has a center and a width ($d$) that corresponds to the longest distance between two points along the interface between the exposed unmelted polycrystalline silicon and the upper surface of the molten silicon. The additional polycrystalline silicon is fed into the rotating crucible at a feed rate ($F$) onto the exposed unmelted polycrystalline thereby maintaining the width ($d$) of the exposed unmelted polycrystalline. Each on-period comprises flowing polycrystalline silicon at a flow rate ($f$) for a duration ($t_{on}$) through a feed device that directs the polycrystalline silicon onto the exposed unmelted polycrystalline, and wherein each off-period comprises interrupting the flow of polycrystalline silicon through the feed device for a duration ($t_{off}$).

Preferably, the process comprises rotating the crucible at a rate ($r$) and forming a depleted molten silicon charge in the rotating crucible, the depleted molten silicon charge having a weight, $w$, the crucible comprising an interior wall and having an inner diameter ($D$). The molten silicon comprises an upper surface. The unmelted polycrystalline silicon comprises an exposed portion that is above the surface of the molten silicon, the exposed unmelted polycrystalline silicon having a center and width (d) that corresponds to the longest distance between two points along the interface between the exposed unmelted polycrystalline silicon and upper surface of the molten silicon. The process further comprises feeding polycrystalline silicon into the rotating crucible by intermittently delivering polycrystalline silicon onto the exposed unmelted polycrystalline silicon thereby maintaining the width of the exposed unmelted polycrystalline silicon ($d$). Each on-period comprises flowing polycrystalline silicon at a flow rate ($f$) for a duration ($t_{on}$) through a feed device that directs the polycrystalline silicon onto the exposed unmelted polycrystalline silicon, and wherein each off-period comprises interrupting the flow of polycrystalline silicon through the feed device for a duration ($t_{off}$).

Other objects and features of this invention will be in part apparent and in part pointed out hereinafter.

BRIEF DESCRIPTION OF THE DRAWINGS

FIG. 1 is a section view of a Czochralski crucible showing an initial loading of chunk polycrystalline silicon.
FIG. 2 is a section view showing the commencement of the intermittent feed process of the present invention wherein granular polycrystalline silicon is fed into the crucible using an off-center vertical feed tube.
FIG. 3 is a section view showing a subsequent on-period of the intermittent feed process of the present invention wherein granular polycrystalline silicon is fed into the crucible using an off-center vertical feed tube.
FIG. 4 is a section view showing the completion of the feeding of granular polycrystalline silicon.
FIG. 5 is a section view showing a silicon melt.
FIG. 6 is a section view showing the commencement of the intermittent feed process of the present invention wherein granular polycrystalline silicon is fed into the crucible using a spray feed tube.
FIG. 7 is a section view showing a subsequent on-period of the intermittent feed process of the present invention wherein granular polycrystalline silicon is fed into the crucible using a spray feed tube.
FIG. 8 contains three views of feeding patterns which may be produced using the intermittent feeding processes of the present invention.
FIG. 9 contains three views of feeding patterns which may be produced using the intermittent feeding processes of the present invention.
FIG. 10 contains a view of a feeding pattern which may be produced using the intermittent feeding processes of the present invention.

DETAILED DESCRIPTION OF THE INVENTION

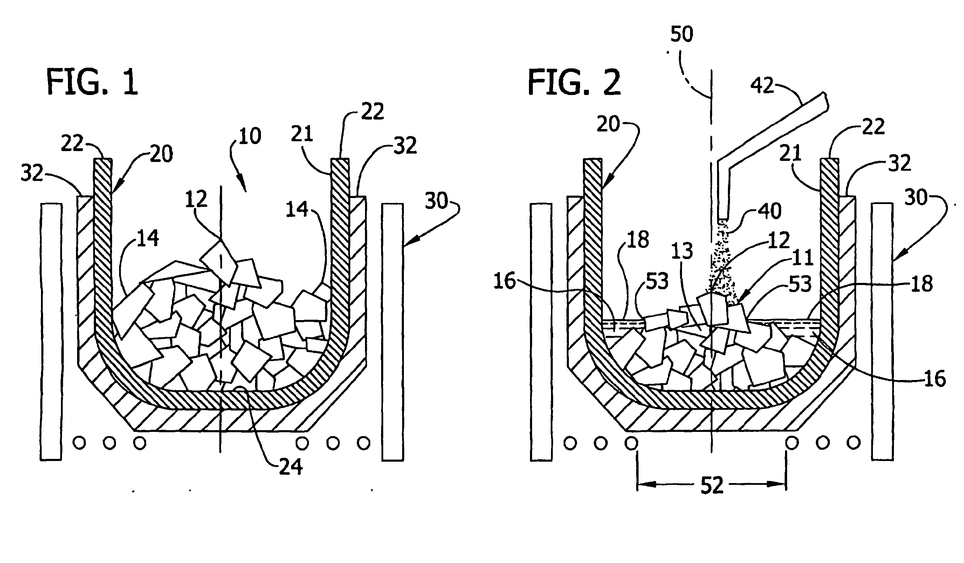

In the present invention, a partially melted charge is formed in a Czochralski (CZ) crucible, the partially melted charge comprising molten silicon and unmelted polycrystalline silicon, the molten silicon having an upper surface, the unmelted polycrystalline silicon comprising an exposed portion that is above the upper surface of the molten silicon. Typically, the partially melted charge is formed by one of or a combination of the following methods: (a) initially loading the crucible with polycrystalline silicon and heating the loaded polycrystalline silicon to form the molten silicon and the unmelted polycrystalline silicon; and/or (b) feeding polycrystalline onto a depleted molten silicon charge to form a partial charge comprising the molten silicon and the unmelted polycrystalline silicon. In accordance with the present invention, additional polycrystalline silicon is fed into the crucible by intermittently delivering polycrystalline silicon onto the exposed unmelted polycrystalline silicon in a manner which preferably decreases the amount of time required to prepare a fully molten silicon melt compared to a continuous feeding method. The invention is described in further detail below with reference to the figures, in which like items are numbered the same in the several figures.
With reference now to FIG. 1, polycrystalline silicon **10** is loaded into a standard Czochralski crucible **20.** Although either granular polycrystalline silicon or chunk polycrystalline silicon could be used for the initial loading, chunk polycrystalline silicon is preferred. The use of granular polycrystalline silicon for the initial loading can result in relatively poor production yields and a high incidence of large void defects forming in the single crystal silicon ingot. It is believed that the granular polycrystalline silicon traps gasses such as argon or hydrogen at the bottom **24** of the crucible **20,** and that these gasses later release as bubbles into the silicon melt during crystal growth. Some of the bubbles become attached to the crystal at the crystal growth interface, thus forming void defects. The use of chunk polycrystalline silicon for the initial loading avoids the formation of these void defects, and generally results in higher yields.
The amount of polycrystalline silicon initially loaded into the crucible is preferably optimized with respect to the quality of the single crystal silicon ingot and production throughput. If too much chunk polycrystalline silicon is loaded into the crucible, higher mechanical stresses occur, and there is also an increased probability of the charge shifting or forming bridges or hangers. Economic, availability or other factors favoring granular polycrystalline silicon may also encourage minimizing the amount of chunk polycrystalline silicon in the initial load. If too little chunk polycrystalline silicon is loaded, however, a considerably greater amount of power is required to melt the charge. The higher wall temperatures associated with the use of such higher power can result in premature crucible degradation. In addition to these factors, the initial loading size will also vary with crucible design, hot zone design and the types of crystal products being produced. Preferably, the weight of the initial loading of chunk polycrystalline silicon is about 40% to about 65% of the total melt weight and more preferably about 50% to about 60% of total melt weight.
Preferably, the initial load of chunk polycrystalline silicon is arranged in the crucible with the center **12** of the polycrystalline silicon **10** being higher than the edge **14.** For example, when preparing the initial 40 kg load of an 80 kg total charge, the center is preferably about 23.5 to about 31 mm higher than the edge. This preferred arrangement along with the preferred amount of initially loaded chunk ensure that the height of the chunk polycrystalline silicon at the edge **14** is less than the height of the completed silicon melt thereby preventing the formation of hangers and/or bridges above the silicon melt. During the melt down, the position of the crucible **20** is such that its top edge **22** is about 10-80 mm above the top edge **32** of the side heater **30,** and preferably about 50 mm. This crucible position is preferably maintained constant for the duration of the meltdown.

As shown in FIG. 2, the loaded polycrystalline silicon **10** is heated (while rotating the crucible at a rate (r)) to form molten silicon **16** and unmelted polycrystalline silicon **11**. The molten silicon **16** has an upper surface **18** above which a portion of the unmelted polycrystalline silicon **11** is exposed. The exposed unmelted polycrystalline having a center **12** and a width **52** that corresponds to the longest distance between two points along the interface between the exposed unmelted polycrystalline silicon and the upper surface of the molten silicon **53**. Preferably, the interface **53** is substantially circular, or stated another way, the interface **53** is approximately equidistant from the center **12** of the exposed unmelted polycrystalline silicon (e.g., a variation of less than about 20% and preferably less than about 10%. The exposed unmelted polycrystalline silicon **11** is essentially an island surrounded by the molten silicon **16** that is formed by heating the crucible **20** with a side heater **30**. To partially melt an initial loading of 40 kg of chunk polycrystalline silicon in a 20 inch (about 51 cm) diameter crucible, for example, the side heater **30** is maintained at a power level of 118 kW. Although the position of the exposed unmelted polycrystalline silicon can vary in the crucible (i.e., the island may move because of floating), the central axis **50** of the crucible preferably passes through the exposed unmelted polycrystalline silicon near the center **12** (e.g., within about 5 cm). Thus, the interface **53** preferably remains approximately equidistant from interior wall **21** of the crucible (e.g., a variation of less than about 20% and preferably less than about 10%.

The extent to which the initial load of polycrystalline silicon is melted to form the polycrystalline silicon island may be specifically defined with respect to the relative amounts of molten silicon **16** and unmelted polycrystalline silicon **11.** By this measure, the ratio of molten silicon **16** to unmelted polycrystalline silicon **11** in the partially melted charge is between about 3:2 and about 4:1 by weight. Alternatively, the extent of melting may be defined with respect to the diameter of the crucible. Preferably, the width **52** of the exposed unmelted polycrystalline silicon ($d$) is between about 65% to about 85% of the crucible diameter ($D$) and still more preferably at about 75% of the crucible diameter. A 40 kg charge was partially melted using the heater power value recited above in about four hours.

In accordance with the present invention, after partially melting the initial load in the crucible, additional polycrystalline silicon is fed into the crucible by intermittently delivering polycrystalline silicon onto the exposed unmelted polycrystalline thereby maintaining the width of the exposed unmelted polycrystalline ($d$) within the above recited values. The intermittent delivery comprising a plurality of alternating on-periods and off-periods wherein each on-period comprises flowing polycrystalline silicon at a flow rate ($f$) for a duration ($t_{on}$) through a feed device that directs the polycrystalline silicon onto the exposed unmelted polycrystalline silicon, and each off-period comprises interrupting the flow of polycrystalline silicon for a duration ($t_{off}$). The flow rate ($f$), the on-period duration ($t_{on}$) and the off-period duration ($t_{off}$) of the intermittent delivery result in feeding the polycrystalline silicon into the crucible at a feed rate ($F$).

As stated above, the foregoing feed parameters are preferably controlled so that polycrystalline silicon is fed onto the exposed unmelted polycrystalline thereby maintaining the diameter of the island between about 65 and about 85% of the diameter of the crucible and more preferably at about 75% of the diameter of the crucible for the most efficient melting without causing crucible damage by over heating the crucible. Specifically, if the island becomes too large (e.g., greater than about 85% of the crucible diameter) the island may touch the wall of the crucible and "freeze over" due to the heat sink effect (i.e., the emissivity of the solid is so much higher than liquid silicon). On the other hand, if the island is too small (e.g., less than about 65% of the crucible diameter), the crucible is damaged by the hotter than necessary temperature.

Experimental results to date suggest that the rotation rate of the crucible (r) is at least about 1 rpm, the flow rate of granular polycrystalline($f$) is at least about 1 g/s, the duration of each on-period ($t_{on}$) is at least about 1 second, the duration of each off-period($t_{off}$) is at least about 1 second, and the feed rate of the intermittently delivered granular polycrystalline silicon($F$) is at least about 1 kg/hr. Preferably, the rotation rate (r) ranges from about 1 rpm to about 5 rpm and more preferably from about 2 rpm to about 3 rpm. Preferably, the flow rate of granular polycrystalline ($f$) ranges from about 5 g/s to about 35 g/s and more preferably from about 10 g/s to about 25 g/s. Preferably, the duration of each on-period ($t_{on}$) ranges from about 2 seconds to about 10 seconds and more preferably from about 4 seconds to about 10 seconds. Preferably, the duration of each off-period ($t_{off}$) is at least about 5 seconds, more preferably it ranges from about 10 seconds to about 30 seconds, still more preferably from about 10 seconds to about 20 seconds and even more preferably from about 10 seconds to about 15 seconds. Preferably, the feed rate of the intermittently delivered granular polycrystalline silicon ($F$) ranges from about 1.5 kg/hr to about 65 kg/hr, more preferably from about 5 kg/hr to about 30 kg/hr, and still more preferably from about 10 kg/hr to about 20 kg/hr.

The polycrystalline silicon fed onto the exposed unmelted polycrystalline silicon is preferably granular polycrystalline silicon. Preferably, the granular polycrystalline silicon is dust free and 90% of the granules (by weight) have a size distribution falling within the range of about 400$\mu$m to about 1400$\mu$m. The type and hydrogen concentration of the granular polycrystalline silicon used in the preferred embodiment of the present invention is not critical as long as the feed rate and other process parameters are controlled to ensure adequate dehydrogenation. The present invention allows the use of granular polycrystalline silicon having a wide range of hydrogen concentrations, including concentrations up to about 500 ppma. Preferably, the hydrogen concentration of the granular polycrystalline silicon fed onto the unmelted polycrystalline silicon is less than about 400 ppma, more preferably less than 50 ppma, and most preferably less than about 20 ppma.

When forming a silicon melt in an accordance with the method of the present invention, it is preferred that the flow, or metering, of the granular polycrystalline silicon is controlled using a delivery device that comprises what is commonly referred to as an angle of repose valve. Preferably, the present invention is carried out using the device described in greater detail by Boone et al. in U.S. Pat. No. 5,059,410 which is commercially available from Crystal Growth Systems of Hanau, Germany. Among the benefits of using a device which comprise an angle of repose valve are increased purity of the grown silicon ingot and longer equipment life due to the decrease in wear from the abrasive granular polycrystalline silicon.

It has been discovered that the melt down can be further influenced by controlling the manner in which the granular polycrystalline silicon is fed onto the exposed unmelted polycrystalline silicon. Specifically, in accordance with the method of the present invention, the polycrystalline silicon is preferably fed in a manner that directs the flow of polycrystalline on a discreet portion of the exposed unmelted polycrystalline silicon. In contrast, continuous feeding method such as described by Holder in U.S. Patent No. 5,588,993 deposits polycrystalline silicon on the center of the exposed unmelted polycrystalline silicon which results in the formation of a conical shaped mass of unmelted polycrystalline silicon having a slope corresponding to the angle of repose. As the granular polycrystalline silicon is fed upon the center (top) of the cone, it travels down the sloping side of the cone along random pathways.

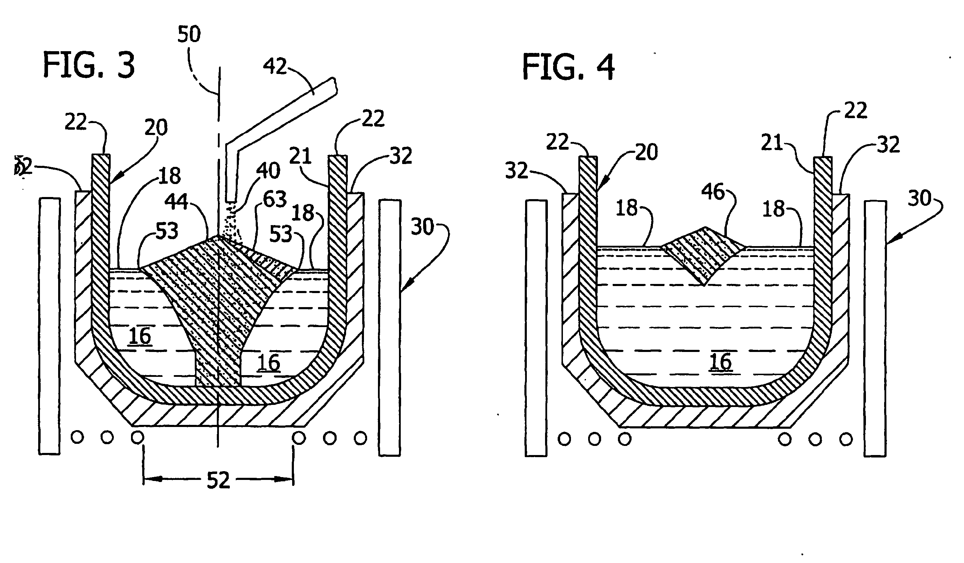

In one embodiment of the present invention, the polycrystalline silicon is fed onto the exposed unmelted polycrystalline silicon as shown in FIGS. 2 and 3. Specifically, the granular polycrystalline silicon **40** is fed onto the exposed unmelted polycrystalline silicon **11** through a vertical-type quartz glass feed tube **42** (such as those commercially available from Quartz Scientific of Cleveland, Ohio). Prior to and during feeding of the granular polycrystalline silicon, the feed tube **42** is movably positioned slightly off the center line **50** of the crucible **20** (e.g., about 10 mm to about 20 mm) and/or slightly away from directly above the center **12** of the exposed unmelted polycrystalline silicon **11.** Feeding commences when the partially melted charge is formed, as defined earlier. By positioning the vertical-type feed tube **42** off-center, the granular polycrystalline silicon **40** is not randomly deposited over the entire exposed unmelted polycrystalline silicon, rather, it is deposited on a portion of the exposed unmelted polycrystalline silicon. Preferably, that portion is a wedge **63** that extends radially outward from about the center **12** of the unmelted polycrystalline silicon to the interface **61** between unmelted polycrystalline silicon and the upper surface of the molten silicon.

By controlling the melt down parameters (e.g., heater power, rotation rate, on-period duration, off-period duration, flow rate, etc.) in conjunction with the off-center feed tube **42,** the granular polycrystalline silicon preferably forms an island **44** over the surface **13** of the exposed unmelted polycrystalline silicon **11,** with the slope of the island **44** equal to the angle of repose for the granular polycrystalline silicon **40.** For the granular polycrystalline silicon available from MEMC Electronic Materials Inc., the angle of repose is approximately 31 degrees. While the granules of granular polycrystalline silicon **40** are resident on the island **44,** the temperature of the granules rises quickly to result in rapid dehydrogenation before the granules become immersed in the molten silicon **16.** Dehydrogenation of the granular polycrystalline silicon may be effected under the same type of atmospheric conditions, typically under an inert gas, as are known in the art for preparing silicon melts in CZ crucibles. After dehydrogenation, the hydrogen concentration of the granules is less than the saturation concentration of hydrogen in silicon at the melting point of silicon. That is, the concentration of hydrogen after dehydrogenation is less than 1 ppma (0.036 ppm by wt.).

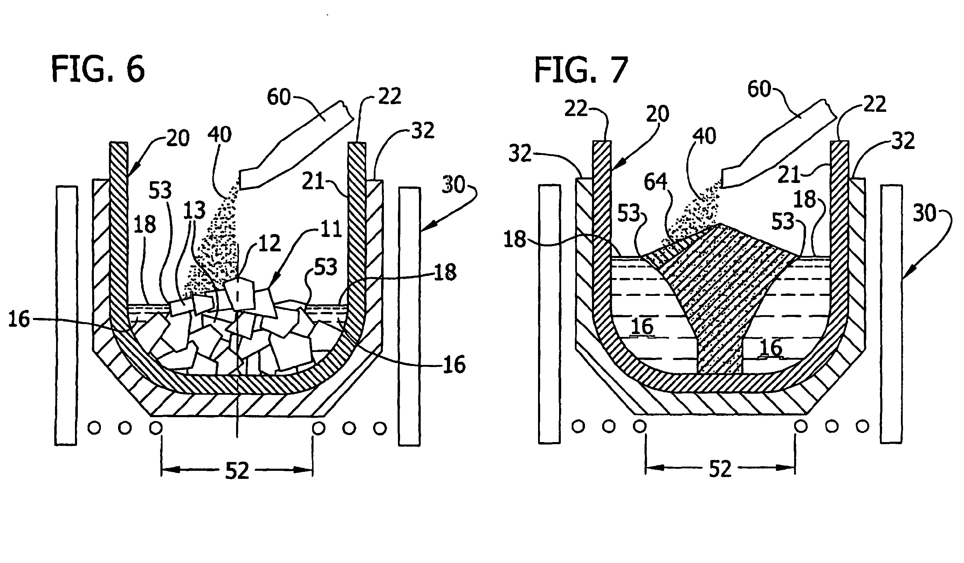

In another embodiment of the present invention, the polycrystalline silicon is fed onto the exposed unmelted polycrystalline silicon as shown in FIGS. 6 and 7. Specifically, the granular polycrystalline silicon **40** is fed onto the exposed unmelted polycrystalline silicon **11** through a spray-type quartz glass feed tube **60** (commercially available from Crystal Growth Systems of Hanau, Germany) which produces a spray of polycrystalline silicon traveling in a direction having a horizontal component. The spray-type feed tube **60** is preferably positioned above the crucible **20** so that the polycrystalline silicon spray deposits on the exposed unmelted polycrystalline silicon **11** in a wedge **64** that is typically larger than the wedge produced using a vertical-type feed tube.

In accordance with the method of the present invention, the melt down process may be further varied by controlling the size of the wedges of granular polycrystalline silicon and the pattern of wedges deposited onto the exposed unmelted polycrystalline silicon. The size of a wedge of polycrystalline silicon fed onto the exposed unmelted polycrystalline silicon is determined, in large part, by the rotation rate and the duration of the on-period ($t_{on}$). For example, feeding the granular polycrystalline silicon for a duration ($t_{on}$) of about 7.5 seconds while rotating the crucible at rate ($r$) of about 2 rpm produces a wedge having a wedge angle of about 90°. Preferably, the wedge has a wedge angle that is less than about 180°. Depending on the process conditions of a particular crystal pulling operation, the size of the wedge can be varied almost infinitely. Experience to date suggests, however, that the wedge angle is preferably less than about 180°, more preferably less than about 120° and still more preferably less than about 90°, and even more preferably ranges from about 40° to about 72°.

As discussed above, the interface between the exposed unmelted polycrystalline silicon and the melted silicon is preferably substantially circular, and in one embodiment of the present invention, the wedge angle is selected such that the substantially circular exposed unmelted polycrystalline silicon can be divided in approximately equal sized segments such as set forth in Table A.

Table A

| Wedge Angle | Number of Equal Sized Segments |
| --- | --- |
| 180° | 2 |
| 120° | 3 |
| 90° | 4 |
| 72° | 5 |
| 60° | 6 |
| 51.4° | 7 |
| 45° | 8 |
| 40° | 9 |
| 36° | 10 |
| 32.7° | 11 |
| 30° | 12 |
| 27.7° | 13 |

Preferably, the melt formation parameters such as the crucible rotation rate ($r$), the on-period duration ($t_{on}$) and the off-period duration ($t_{off}$) are controlled so that the flow of granular polycrystalline silicon through the feed device is directed onto a portion of the exposed unmelted polycrystalline silicon (e.g., a wedge) that does not substantially overlap with a portion of the exposed unmelted polycrystalline silicon upon which an immediately preceding on-period polycrystalline silicon feed was deposited (e.g., the immediately preceding wedge). The term substantial overlap is defined herein as being greater than about 30%. More preferably, the overlap is less than about 30%, still more preferably less than about 20%, even more preferably less than about 10%, yet still more preferably less than about 5%, and most preferably there is no overlap.

Depending on the location where and/or the time when the wedges of granular polycrystalline silicon are deposited, the melting rate of the fed granular polycrystalline silicon varies significantly. Experimental results to date suggest that the intermittent feeding process can significantly shorten the feed time compared to a continuous feed process by depositing polycrystalline silicon on the entire exposed unmelted polycrystalline silicon prior to redepositing granular polycrystalline on any wedge. This can be accomplished using a wide variety of feed patterns, some of which are as follows:

(a) each subsequent wedge is deposited adjacent to the immediately preceding wedge and within one rotation of the crucible after the immediately preceding wedge (see, e.g., the 6 segment feed pattern depicted in FIG. 8a wherein the order in which the wedges are deposited is indicated by the numbers within the wedges);
(b) each subsequent wedge is deposited adjacent to the immediately preceding wedge and following at least one rotation of the crucible after the immediately preceding wedge;
(c) each subsequent wedge is deposited nearly opposite from the immediately preceding wedge, and adjacent to the second-most recent wedge and within one rotation of the crucible after the second-most recent wedge (see, e.g., the 3, 7 and 13 segment feed patterns depicted in FIGS. 9a, 9b and 9c); and
(d) each subsequent wedge is deposited nearly opposite from the immediately preceding wedge, and adjacent to the second-most recent wedge and following at least one rotation of the crucible after the second-most recent wedge.

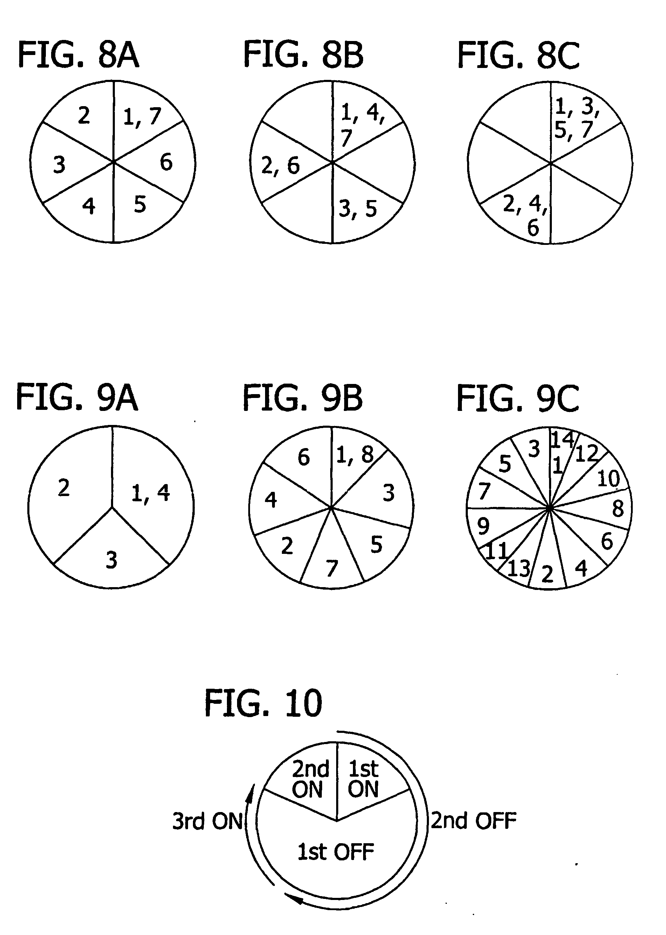

On the other hand, experimental results to date suggest that more frequent deposition of granular polycrystalline silicon on particular portions of the exposed unmelted polycrystalline silicon can significantly lengthen the feed time compared to continuous feed process. Or stated another way, polycrystalline silicon is redeposited on a wedge prior to the depositing granular polycrystalline silicon on the entire exposed unmelted polycrystalline silicon. Referring to FIG. 8b, for example, the 36° wedges are deposited after about every 108° of crucible rotation which results in redepositing granular polycrystalline silicon on the same location every third on-period. Similarly, the feed pattern depicted in FIG.

8c results in redepositing granular silicon on the same location every other on-period. Feed patterns which lengthen the feed time may be beneficial in circumstances when a heater can only melt the granular polycrystalline silicon at low feed rates (e.g., less than about 15 kg/hr) so that the exposed unmelted polycrystalline silicon does not exceed about 85% of the crucible diameter.

The side heater **30** typically remains energized during the feeding of granular polycrystalline silicon **40** onto the unmelted polycrystalline silicon **11.** For example, when forming an 80 kg melt, the power level of the side heater is maintained at about 118 kW. As shown in FIG. 3, the combined effect of the continued heating during feeding of granular polycrystalline silicon is to result in a solidified silicon mass **46** forming underneath the island **44.** In the preferred embodiment, the solidified silicon mass **46** comprises both chunk polycrystalline silicon from the initial loading and granular polycrystalline silicon from the latter feeding.

Feeding continues in accordance with the parameters of the intermittent delivery process until the total amount of silicon mass desired in the final silicon melt has been charged into the crucible **20.** For an 80 kg total melt mass in which 40 kg of chunk polycrystalline silicon was used for the initial loading, 40 kg of granular polycrystalline silicon **40** must be charged through the feed tube **42.**

However, larger total charges may also be realized where the crucible **20** can accommodate the additional silicon melt. After the feeding of granular polycrystalline silicon **40** is complete, the feed tube **42** can be positioned away from the center of the crucible **20** to allow for crystal pulling. At this point, as shown in FIG. 4, the bulk of the silicon in the crucible **20** is molten silicon **16,** with a relatively smaller amount of solidified silicon mass **46** remaining.

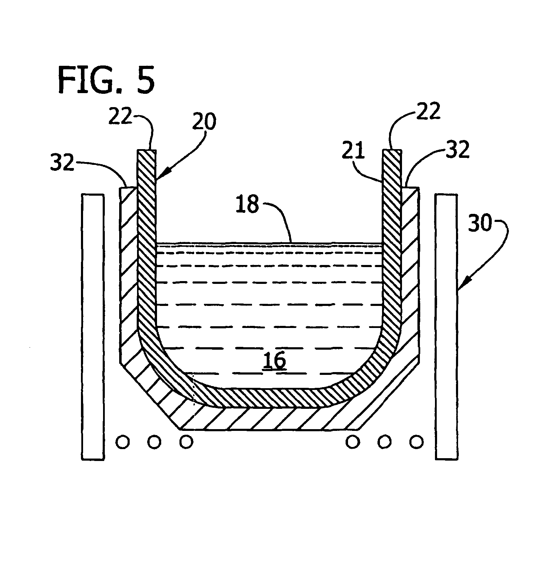

The granular polycrystalline silicon and the unmelted polycrystalline silicon, collectively comprising the solidified silicon mass **46,** are further melted to form a silicon melt. As shown in FIG. 5, the silicon melt comprises 100% molten silicon **16.** When forming an 80 kg melt, the power level for the side heater **30** is preferably maintained at 118 kW to effectuate the final melting in approximately 30 minutes.

To assist in the selection of the intermittent delivery parameters Table B contains the calculated feed rate for various on/off-period combinations and polycrystalline silicon feed rates while rotating the crucible at about 2 rpm.

Table B

| Segments | 3 | 4 | 5 | 7 | 6 | 9 | 8 | 13 | 10 | 12 |
|---|---|---|---|---|---|---|---|---|---|---|
| Time ON (s) | 10.0 | 7.5 | 6.0 | 4.3 | 5.0 | 3.3 | 3.8 | 2.3 | 3.0 | 2.5 |
| Time OFF (s) | 10.0 | 15. 0 | 12. 0 | 12.9 | 20.0 | 13.3 | 22.5 | 13.8 | 24.0 | 25.0 |
| Polycryst alline silicon Flow rate (g/s) | Calculated Feed Rate (kg/hr) | | | | | | | | | |
| 5 | 9.0 | 6.0 | 6.0 | 4.5 | 3.6 | 3.6 | 2.6 | 2.6 | 2.0 | 1.6 |
| 10 | 18.0 | 12.0 | 12.0 | 9.0 | 7.2 | 7.2 | 5.1 | 5.1 | 4.0 | 3.3 |
| 15 | 27.0 | 18.0 | 18.0 | 13.5 | 10.8 | 10.8 | 7.7 | 7.7 | 6.0 | 4.9 |
| 20 | 36.0 | 24.0 | 24.0 | 18.0 | 14.4 | 14.4 | 10.3 | 10.3 | 8.0 | 6.5 |
| 25 | 45.0 | 30.0 | 30.0 | 22.5 | 18.0 | 18.0 | 12.9 | 12.9 | 10.0 | 8.2 |
| 30 | 54.0 | 36.0 | 36.0 | 27.0 | 21.6 | 21.6 | 15.4 | 15.4 | 12.0 | 9.8 |
| 35 | 63.0 | 42.0 | 42.0 | 31.5 | 25.2 | 25.2 | 18.0 | 18.0 | 14.0 | 11.5 |

The feed rate is calculated according to the following expression:

$$FeedRate\left(\frac{kg}{hr}\right) = \frac{3600\left(\frac{s}{hr}\right) \times Time\,On\,(s) \times Polysilicon\,Flow\,Rate\left(\frac{g}{s}\right)}{[Time\,On\,(s) + Time\,Off\,(s)] \times 1000\left(\frac{g}{kg}\right)}$$

By way of example, the 3, 7 and 13 segment deposition patterns are depicted in FIGS. 9a, 9b and 9c, respectively.

Although the foregoing discussion is directed to the initial charging (loading and feeding of polycrystalline silicon) and meltdown of the polycrystalline silicon to form a silicon melt in a crucible, the present invention is also directed to the recharging of a crucible containing a depleted molten silicon charge. A depleted molten charge is typically formed by pulling a single crystal silicon ingot from a previously formed silicon melt; a portion of the silicon melt remains in the crucible after the ingot is separated from the silicon melt. Preferably, the ingot pulled from the previously formed silicon melt leaves a depleted molten silicon charge having a weight (w) that is about 15% to about 40% by weight of the silicon melt that is to be formed by the recharge. More preferably, weight of the depleted molten silicon charge (w) is about 20% to about 30% by weight of the silicon melt that is to be formed by the recharge. In accordance with the present invention, polycrystalline silicon is fed into the rotating crucible by delivering the polycrystalline silicon onto the depleted molten silicon charge to form a partial charge comprising molten silicon and unmelted polycrystalline silicon, the molten silicon comprising an upper surface, the unmelted polycrystalline silicon comprising an exposed portion that is above the surface of the molten silicon, the exposed unmelted polycrystalline silicon having a center and width, d, that corresponds to the longest distance between two points along the interface between the exposed unmelted polycrystalline silicon and upper surface of the molten silicon. The polycrystalline silicon fed into the crucible to form the partial charge may be fed by any appropriate method (e.g., by continuous feed and/or by intermittent delivery). Preferably, however, the partial charge is formed in accordance with the intermittent delivery described in detail herein. For example, to rapidly build up the exposed unmelted polycrystalline silicon it may be beneficial to frequently deposit polycrystalline silicon on particular portions of the depleted molten silicon and/or exposed unmelted polycrystalline silicon such as depicted in FIGS. 8b and 8c. The recharging process continues by feeding polycrystalline silicon into the rotating crucible by intermittently delivering polycrystalline silicon onto the exposed unmelted polycrystalline silicon thereby maintaining the width of the exposed unmelted polycrystalline silicon (d) as described in detail herein. The unmelted polycrystalline silicon and the intermittently delivered polycrystalline silicon are melted to form the silicon melt.

## Example 1

About 40 kg of chunk polycrystalline that was loaded into a 20 inch (51 cm) diameter crucible and heated to form molten silicon and unmelted polycrystalline silicon. A vertical-type feed tube positioned slightly off the centerline of the crucible (about 15 mm) and approximately 10 inches (25 cm) above the melt surface was used to feed about 40 kg of granular polycrystalline silicon into the crucible for a total charge of about 80 kg. The granular polycrystalline silicon flow rate ($f$) was approximately 17 grams/second from the hopper, through the injector tube and into the crucible.

The furnace side heater power was about 118 kW and the crucible rotation rate ($r$) was about 2 RPM. The chunk polycrystalline silicon was partially melted after about 3.5 hours (i.e., the diameter of the chunk polycrystalline island, centered in the crucible, was about 75% of the crucible diameter). Initially, the duration of the on-period ($t_{on}$) was set to about 5 seconds and the duration of the off-period ($t_{off}$) was set to about 20 seconds to yield a feed rate ($F$) of about 11.5 kg/hr. The initial on/off-period combination was chosen to provide a feed rate that, based upon experience with continuous feeding, would maintain the width (d) of the unmelted polycrystalline silicon (island) diameter of the island at about 75% of crucible diameter (D) (i.e., about 38 cm). The foregoing settings resulted in the 6 segment feed pattern depicted in FIG. 8a.

At the $t_{on}$/$t_{off}$ settings of 5s/20s, the melting rate was much faster than expected and the exposed unmelted polycrystalline silicon (island) shrank in size to less than about 75% of the crucible diameter. After about 1 hour, the $t_{off}$ was decreased to about 15 seconds to yield a feed rate of about 14.5 kg/hr. With this $t_{on}$/$t_{off}$ combination, the island grew quickly in size to about 75% of the crucible diameter. After about 2 hours at the 5s/15s setting (depicted in FIG. 8b), it was necessary to reduce the $t_{off}$ to about ten seconds to maintain the diameter of the island at about 75% of the crucible diameter. The 5s/10s combination (depicted in FIG. 8c) resulted in a feed rate of about 19.2 kg/hr. The 40 kg granular polycrystalline silicon addition was completed in about 3 hours and 15 minutes and the island completed melting after another 30 minutes. The total melting time was about 7 hours and 15 minutes.

Compared to continuously feeding granular polycrystalline silicon onto a chunk polycrystalline silicon initial charge which can typically feed/melt granular polycrystalline at about 8-12 kg/hr while maintaining the width of the island at about 75% of the crucible diameter, the melting rate of the granular polycrystalline silicon fed at 5s/20s was surprisingly fast (i.e., the island was shrinking in size below about 75% of the crucible diameter). Surprisingly, the feeding/melting rates at 5s/15s and 5s/10s were surprisingly slow for a melt mass that had been increased to about 52 kg and 60 kg, respectively.

## Example 2

Based on the test detailed in Example 1, it was determined that the intermittent feeding process can significantly increase the feed rate ($F$) at which an appropriate island width may be maintained thereby decreasing the feed time compared to a continuous feed process. Specifically, it was determined that maximizing the degree of rotation between subsequently deposited wedges and maximizing number of on-periods before redepositing feed material on a particular portion, or segment, of the polycrystalline island greatly increased the flow rate at which the 75% crucible diameter island size could be maintained.

In view of the foregoing principles, an optimum set of parameters were determined and tested in order to maximize the feeding/melting rate of granular polycrystalline silicon into the loaded crucible. As in Example 1, the crucible was initially loaded with 40 kg of chunk polycrystalline silicon, the gravity feeder delivered granular polycrystalline silicon at a flow rate ($f$) of about 17 g/s and the side heater power was at about 118 kW. A deposition pattern depicted in FIG. 10 was selected along with an on/off-period combination of about 5s/12s. It was determined that crucible should be rotated at a rate ($r$) of about 2.1 rpm, based on the following expression :

$$\text{RPM} = 60s/(1 \times \text{number of seconds ON} + 2 \times \text{number of seconds OFF}).$$

In accordance with the foregoing parameters the granular polycrystalline was fed at a rate ($F$) of about 20 kg/hr onto the exposed unmelted polycrystalline (island) while maintaining a width of the island at about 75% of the crucible diameter. Thus, the intermittent feeding process reduced the feeding time to about 2 hours which is about half of the time required for a continuous feeding process.

In light of the detailed description of the invention and the examples presented above, it can be appreciated that the several objects of the invention are achieved.

The explanations and illustrations presented herein are intended to acquaint others skilled in the art with the invention, its principles, and its practical application. Those skilled in the art may adapt and apply the invention in its numerous forms, as may be best suited to the requirements of a particular use. Accordingly, the specific embodiments of the present invention as set forth are not intended as being exhaustive or limiting of the invention.

When introducing elements of the present invention or the preferred embodiment(s) thereof, the articles "a", "an", "the" and "said" are intended to mean that there are one or more of the elements. The terms "comprising", "including" and "having" are intended to be inclusive and mean that there may be additional elements other than the listed elements.

**Claims**

1. A process for preparing a silicon melt in a crucible for use in growing a single crystal silicon ingot by the Czochralski method, the process comprising:

    a. forming a partially melted charge in the crucible, the partially melted charge comprising molten silicon and unmelted polycrystalline silicon, the molten silicon having an upper surface, the unmelted polycrystalline silicon comprising an exposed portion that is above the upper surface of the molten silicon;
    b. rotating the crucible;
    c. feeding additional polycrystalline silicon into the rotating crucible by intermittently delivering the additional polycrystalline silicon onto the exposed unmelted polycrystalline silicon, the intermittent delivery comprising a plurality of alternating on-periods and off-periods, wherein each on-period comprises flowing the additional polycrystalline silicon through a feed device that directs the flow of the additional polycrystalline silicon onto the unmelted polycrystalline silicon of the partially melted charge in the crucible for an on-duration, and each off-period comprises interrupting the flow of the additional polycrystalline silicon for an off duration; and
    d. melting the unmelted polycrystalline silicon and the additional polycrystalline silicon to form the silicon melt in the crucible from which the single crystal silicon ingot is grown.

2. The process as set forth in claim 1 further comprising forming the partially melted charge in step a. by loading the crucible with polycrystalline silicon and heating the loaded polycrystalline silicon to form the partially melted charge.

3. The process as set forth in claim 2, wherein the crucible comprises an interior wall and has an inner diameter D, wherein the loaded crucible is rotated at a rate, r, wherein the exposed unmelted polycrystalline has a center and a width, $d$, that corresponds to the longest distance between two points along the interface between the exposed unmelted polycrystalline silicon and the upper surface of the molten silicon, wherein the additional polycrystalline silicon is fed into the rotating crucible at a feed rate, $F$, thereby maintaining the width of the exposed unmelted polycrystalline silicon, $d$, wherein each on-period comprises flowing the additional polycrystalline silicon at a flow rate, $f$, for a duration, $t_{on}$, through a feed device that directs the additional polycrystalline silicon onto the exposed unmelted polycrystalline silicon, and wherein each off-period comprises interrupting the flow of the additional polycrystalline silicon through the feed device for a duration $t_{off}$.

4. The process as set forth in claim 3 wherein the interface between the unmelted polycrystalline silicon and the upper surface of the molten silicon is approximately equidistant from the center of the unmelted polycrystalline silicon.

5. The process as set forth in claim 4 wherein the interface between unmelted polycrystalline silicon and the upper surface of the molten silicon is approximately equidistant from the interior wall of the crucible.

6. The process as set forth in claim 5 wherein the polycrystalline silicon that is loaded into the crucible is chunk polycrystalline silicon and the additional polycrystalline silicon fed into the crucible is granular polycrystalline silicon.

7. The process as set forth in claim 6 wherein the loaded chunk polycrystalline silicon comprises about 40% to about 65% by weight of the silicon melt.

8. The process as set forth in any of claims 6 or 7 wherein $d$ ranges from about 65% to about 85% of $D$.

9. The process as set forth in any of claims 6-8 wherein $r$ is at least about 1 rpm.

10. The process as set forth in any of claims 6-8 wherein $r$ ranges from about 2 rpm to about 3 rpm.

11. The process as set forth in any of claims 6-10 wherein $F$ is at least about 1 kg/hr.

12. The process as set forth in any of claims 6-11 wherein $F$ ranges from about 10 kg/hr to about 20 kg/hr.

13. The process as set forth in any of claims 6-12 wherein $f$ is at least about 1 g/s.

14. The process as set forth in any of claims 6-13 wherein $f$ ranges from about 10 g/s to about 25 g/s.

15. The process as set forth in any of claims 6-14 wherein $t_{on}$ is at least about 1 second.

16. The process as set forth in any of claims 6-15 wherein $t_{on}$ ranges from about 2 seconds to about 10 seconds.

17. The process as set forth in any of claims 6-16 wherein $t_{off}$ is at least about 1 second.

18. The process as set forth in any of claims 6-17 wherein $t_{off}$ is at least about 5 seconds.

19. The process as set forth in any of claims 6-18 wherein $t_{off}$ ranges from about 10 seconds to about 30 seconds.

20. The process as set forth in any of claims 6-19 wherein the flow of the granular polycrystalline silicon is interrupted during the off-period using an angle of repose valve.

21. The process as set forth in any of claims 6-20 wherein the feed device directs the granular polycrystalline silicon onto a portion of the exposed unmelted polycrystalline.

22. The process as set forth in claim 21 wherein the feed device through which the granular polycrystalline silicon is flowed is a vertical-type feed tube that is positioned so that it is not directly above the center of the exposed unmelted polycrystalline silicon.

23. The process as set forth in claim 21 wherein the feed device through which the granular polycrystalline silicon is flowed is a spray-type feed tube.

24. The process as set forth in claim 21 wherein the portion of the exposed unmelted polycrystalline upon which the granular polycrystalline silicon is delivered is a wedge that extends radially outward from about the center to the interface between the unmelted polycrystalline silicon and the upper surface of the molten silicon.

25. The process as set forth in claim 24 wherein the wedge has a wedge angle that is about 180°.

26. The process as set forth in claim 24 wherein the wedge has a wedge angle that is less than about 180°.

27. The process as set forth in claim 24 wherein the wedge has a wedge angle that ranges from about 40° to about 72°.

28. The process as set forth in any of claims 24 to 27 wherein each wedge on the exposed unmelted polycrystalline silicon does not substantially overlap with the immediately preceding wedge.

**29.** The process as set forth in claim 28 wherein granular polycrystalline silicon is deposited on the entire exposed unmelted polycrystalline silicon prior to redepositing granular polycrystalline silicon on any wedge.

**30.** The process as set forth in claim 29 wherein each subsequent wedge is deposited adjacent to the immediately preceding wedge and within one rotation of the crucible after the immediately preceding wedge.

**31.** The process as set forth in claim 29 wherein each subsequent wedge is deposited adjacent to the immediately preceding wedge and following at least one rotation of the crucible after the immediately preceding wedge.

**32.** The process as set forth in claim 29 wherein each subsequent wedge is deposited nearly opposite from the immediately preceding wedge, and adjacent to the second-most recent wedge and within one rotation of the crucible after the second-most recent wedge.

**33.** The process as set forth in claim 29 wherein each subsequent wedge is deposited nearly opposite from the immediately preceding wedge, and adjacent to the second-most recent wedge and following at least one rotation of the crucible after the second-most recent wedge.

**34.** The process as set forth in claim 28 wherein granular polycrystalline silicon is redeposited on a wedge prior to the depositing granular polycrystalline silicon on the entire exposed unmelted polycrystalline silicon.

**35.** The process as set forth in claim 1, wherein the crucible is rotated at a rate, r; wherein the crucible comprises an interior wall and has an inner diameter D; and wherein the exposed unmelted polycrystalline has a center and width, d, that corresponds to the longest distance between two points along the interface between the exposed unmelted polycrystalline silicon and the upper surface of the molten silicon, wherein the process further comprises:

a. forming the partially melted charge in the crucible by feeding the unmelted polycrystalline silicon onto a depleted molten silicon charge having a weight, w, such that the exposed unmelted polycrystalline silicon has a center and width, d, that corresponds to the longest distance between two points along the interface between the exposed unmelted polycrystalline silicon and upper surface of the molten silicon;

b. wherein the feeding of the additional polycrystalline silicon onto the exposed unmelted polycrystalline silicon maintains the width of the exposed unmelted polycrystalline silicon, $d$; and

c. wherein the on-period comprises the flow of additional polycrystalline silicon at a flow rate, $f$, for a duration, $t_{on}$, and the off-period interrupts the flow of additional polycrystalline silicon through the feed device for a duration, $t_{off}$.

**36.** The process as set forth in claim 35 wherein w is about 15% to about 40% by weight of the silicon melt.

**37.** The process as set forth in any of claims 35 or 36 wherein the interface between the unmelted polycrystalline silicon and the upper surface of the molten silicon is approximately equidistant from the center of the unmelted polycrystalline silicon and approximately equidistant from the interior wall of the crucible.

**38.** The process as set forth in any of claims 35-37 wherein the polycrystalline silicon and the additional polycrystalline silicon fed into the crucible are granular polycrystalline silicon.

**39.** The process as set forth in any of claims 35-38 wherein $d$ ranges from about 65% to about 85% of $D$.

**40.** The process as set forth in any of claims 35-39 wherein $r$ ranges from about 1 rpm to about 5 rpm.

**41.** The process as set forth in any of claims 35-40 wherein $f$ ranges from about 5 g/s to about 35 g/s.

**42.** The process as set forth in any of claims 35-41 wherein $t_{on}$ ranges from about 2 seconds to about 10 seconds.

**43.** The process as set forth in any of claims 35-42 wherein $t_{off}$ is at least about 5 seconds.

**44.** The process as set forth in any of claims 35 to 43 wherein the feed device directs the granular polycrystalline silicon onto a portion of the exposed unmelted polycrystalline.

**45.** The process as set forth in any of claims 35 to 44 wherein the portion of the exposed unmelted polycrystalline silicon upon which the granular polycrystalline silicon is delivered is a wedge that extends radially outward from about the center to the interface between the unmelted polycrystalline silicon and the upper surface of the molten silicon.

46. The process as set forth in claim 45 wherein the wedge has a wedge angle that is less than about 180°.

47. The process as set forth in claim 45 wherein the wedge has a wedge angle that ranges from about 40° to about 72°.

48. The process as set forth in any of claims 45-47 wherein each wedge on the exposed unmelted polycrystalline silicon does not substantially overlap with the immediately preceding wedge.

49. The process as set forth in claim 48 wherein granular polycrystalline silicon is deposited on the entire exposed unmelted polycrystalline silicon prior to redepositing granular polycrystalline silicon on any wedge.

50. The process as set forth in claim 49 wherein each subsequent wedge is deposited adjacent to the immediately preceding wedge and within one rotation of the crucible after the immediately preceding wedge.

51. The process as set forth in claim 49 wherein each subsequent wedge is deposited adjacent to the immediately preceding wedge and following at least one rotation of the crucible after the immediately preceding wedge.

52. The process as set forth in claim 49 wherein each subsequent wedge is deposited nearly opposite from the immediately preceding wedge, and adjacent to the second-most recent wedge and within one rotation of the crucible after the second-most recent wedge.

53. The process as set forth in claim 49 wherein each subsequent wedge is deposited nearly opposite from the immediately preceding wedge, and adjacent to the second-most recent wedge and following at least one rotation of the crucible after the second-most recent wedge.

54. The process as set forth in claim 48 wherein granular polycrystalline silicon is redeposited on a wedge prior to the depositing granular polycrystalline silicon on the entire exposed unmelted polycrystalline silicon.

55. The process as set forth any of claims 1-54 further comprising growing a single crystal silicon ingot by the Czochralski method from the silicon melt in the crucible.

**Patentansprüche**

1. Verfahren zur Herstellung einer Siliziumschmelze in einem Tiegel zur Verwendung für das Ziehen eines Einkristall-Siliziumblocks mittels des Czochralski-Verfahrens, wobei das Verfahren umfaßt:

   a. das Bilden einer teilweise geschmolzenen Beschickung in dem Tiegel, wobei die teilweise geschmolzene Beschickung geschmolzenes Silizium und nicht-geschmolzenes polykristallines Silizium umfaßt, wobei das geschmolzene Silizium eine obere Oberfläche aufweist, und wobei das nicht-geschmolzene polykristalline Silizium einen ausgesetzten Anteil umfaßt, der oberhalb der oberen Oberfläche des geschmolzenen Siliziums liegt;
   b. das Rotieren des Tiegels;
   c. das Beschicken von zusätzlichem polykristallinen Silizium in den rotierenden Tiegel durch periodisches Beschicken des zusätzlichen polykristallinen Siliziums auf das ausgesetzte nicht-geschmolzene polykristalline Silizium, wobei die periodische Beschickung eine Vielzahl von alternierenden Ein-Perioden bzw. eingeschalteten Perioden und Aus-Perioden bzw. ausgeschalteten Perioden umfaßt, wobei jede Ein-Periode das Strömen des zusätzlichen polykristallinen Siliziums durch eine Beschickungsvorrichtung, welche den Strom des zusätzlichen polykristallinen Siliziums auf das nicht-geschmolzene polykristalline Silizium der teilweise geschmolzenen Beschickung in dem Tiegel für eine Ein-Zeitdauer bzw. eingeschaltete Zeitdauer richtet, umfaßt und jede Aus-Periode das Unterbrechen des Stroms des zusätzlichen polykristallinen Siliziums für eine Aus-Zeitdauer bzw. ausgeschaltete Zeitdauer umfaßt; und
   d. das Schmelzen des nicht-geschmolzenen polykristallinen Siliziums und des zusätzlichen polykristallinen Siliziums unter Bildung der Siliziumschmelze in dem Tiegel, wovon der Einkristall-Siliziumblock gezogen wird.

2. Verfahren gemäß Anspruch 1, weiter umfassend das Bilden der teilweise geschmolzenen Beschickung in Schritt a. durch Beladen des Tiegels mit polykristallinem Silizium und Erhitzen des beladenen polykristallinen Siliziums unter Bildung der teilweise geschmolzenen Beschickung.

3. Verfahren gemäß Anspruch 2, wobei der Tiegel eine innere Wand umfaßt und einen inneren Durchmesser $D$ aufweist, wobei der beladene Tiegel mit einer Geschwindigkeit $r$ rotiert wird, wobei das ausgesetzte nicht-geschmolzene polykristalline Silizium ein Zentrum bzw. eine Mitte und eine Breite bzw. Ausdehnung $d$ aufweist, die dem längsten Abstand zwischen zwei Punkten entlang der Grenzfläche zwischen dem ausgesetzten nicht-geschmolzenen polykristallinen Silizium und der oberen Oberfläche des geschmolzenen Siliziums entspricht, wobei das zusätzliche polykristalline Silizium in den rotierenden Tiegel mit einer Beschickungsrate $F$ beschickt wird, wobei die Breite des ausgesetzten nicht-geschmolzenen polykristallinen Siliziums $d$ beibehalten wird, wobei jede Ein-Periode das Strömen des zusätzlichen polykristallinen Siliziums mit einer Fließgeschwindigkeit $f$ für eine Zeitdauer $t_{on}$ durch eine Beschickungseinrichtung, welche das zusätzliche polykristalline Silizium auf das ausgesetzte nicht-geschmolzene polykristalline Silizium richtet, umfaßt und wobei jede Aus-Periode das Unterbrechen des Stromes des zusätzlichen polykristallinen Siliziums durch die Beschickungsvorrichtung für eine Dauer $t_{off}$ umfaßt.

4. Verfahren gemäß Anspruch 3, wobei die Grenzfläche zwischen dem nicht-geschmolzenen polykristallinen Silizium und der oberen Oberfläche des geschmolzenen Siliziums annähernd equidistant von der Mitte des nicht-geschmolzenen polykristallinen Siliziums ist.

5. Verfahren gemäß Anspruch 4, wobei die Grenzfläche zwischen nichtgeschmolzenem polykristallinen Silizium und der oberen Oberfläche des geschmolzenen Siliziums annähernd equidistant von der inneren Wand des Tiegels ist.

6. Verfahren gemäß Anspruch 5, wobei das polykristalline Silizium, das in den Tiegel beladen wird, polykristalliner Siliziumbrocken bzw. -stück ist, und das zusätzliche polykristalline Silizium, welches in den Tiegel beschickt wird, granuläres polykristallines Silizium ist.

7. Verfahren gemäß Anspruch 6, wobei der zugesetzte polykristalline Siliziumbrocken etwa 40 Gew.-% bis etwa 65 Gew.-% der Siliziumschmelze umfassen.

8. Verfahren gemäß einem der Ansprüche 6 oder 7, wobei $d$ von etwa 65% bis etwa 85% von D reicht.

9. Verfahren gemäß einem der Ansprüche 6 bis 8, wobei $r$ mindestens etwa 1 Upm ist.

10. Verfahren gemäß einem der Ansprüche 6 bis 8, wobei $r$ von etwa 2 Upm bis etwa 3 Upm reicht.

11. Verfahren gemäß einem der Ansprüche 6 bis 10, wobei F mindestens etwa 1 kg/h beträgt.

12. Verfahren gemäß einem der Ansprüche 6 bis 11, wobei $F$ von etwa 10 kg/h bis etwa 20 kg/h reicht.

13. Verfahren gemäß einem der Ansprüche 6 bis 12, wobei $f$ mindestens etwa 1 g/s beträgt.

14. Verfahren gemäß einem der Ansprüche 6 bis 13, wobei $f$ von etwa 10 g/s bis etwa 25 g/s reicht.

15. Verfahren gemäß einem der Ansprüche 6 bis 14, wobei $t_{on}$ mindestens etwa 1 Sekunde beträgt.

16. Verfahren gemäß einem der Ansprüche 6 bis 15, wobei $t_{on}$ von etwa 2 Sekunden bis etwa 10 Sekunden reicht.

17. Verfahren gemäß einem der Ansprüche 6 bis 16, wobei $t_{off}$ mindestens etwa 1 Sekunde beträgt.

18. Verfahren gemäß einem der Ansprüche 6 bis 17, wobei $t_{off}$ mindestens etwa 5 Sekunden beträgt.

19. Verfahren gemäß einem der Ansprüche 6 bis 18, wobei $t_{off}$ von etwa 10 Sekunden bis etwa 30 Sekunden reicht.

20. Verfahren gemäß einem der Ansprüche 6 bis 19, wobei der Strom des granulären polykristallinen Siliziums während der Aus-Periode unter Verwendung eines Schüttwinkelventils unterbrochen wird.

21. Verfahren gemäß einem der Ansprüche 6 bis 20, wobei die Beschickungsvorrichtung das granuläre polykristalline Silizium auf einen Anteil des ausgesetzten nicht-geschmolzenen polykristallinen Siliziums richtet.

**22.** Verfahren gemäß Anspruch 21, wobei die Beschickungsvorrichtung, durch welche das granuläre polykristalline Silizium strömt, ein Beschickungsrohr vom vertikalem Typ ist, welches derart angeordnet ist, daß es nicht direkt oberhalb der Mitte des ausgesetzten nicht-geschmolzenen polykristallinen Siliziums ist.

**23.** Verfahren gemäß Anspruch 21, wobei die Beschickungsvorrichtung, durch welche das granuläre polykristalline Silizium strömt, ein Beschickungsrohr vom Sprühtyp ist.

**24.** Verfahren gemäß Anspruch 21, wobei der Anteil des ausgesetzten nicht-geschmolzenen polykristallinen Siliziums, worauf das granuläre polykristalline Silizium beschickt wird, eine Keilfläche bzw. ein Keil ist, der sich radial nach außen von etwa der Mitte zu der Grenzfläche zwischen dem nicht-geschmolzenen polykristallinen Silizium und der oberen Oberfläche des geschmolzenen Siliziums erstreckt.

**25.** Verfahren gemäß Anspruch 24, wobei der Keil einen Keilwinkel aufweist, der etwa 180° beträgt.

**26.** Verfahren gemäß Anspruch 24, wobei der Keil einen Keilwinkel aufweist, der weniger als etwa 180° beträgt.

**27.** Verfahren gemäß Anspruch 24, wobei der Keil einen Keilwinkel aufweist, der zwischen etwa 40° bis etwa 72° liegt.

**28.** Verfahren gemäß einem der Ansprüche 24 bis 27, wobei jeder Keil auf dem ausgesetzten nicht-geschmolzenen polykristallinen Silizium im wesentlichen nicht mit dem unmittelbar vorhergehenden Keil überlappt.

**29.** Verfahren gemäß Anspruch 28, wobei granuläres polykristallines Silizium auf dem gesamten ausgesetzten nicht-geschmolzenen polykristallinen Silizium vor dem Wiederabscheiden von granulärem polykristallinen Silizium auf jedwedem Keil abgeschieden wird.

**30.** Verfahren gemäß Anspruch 29, wobei jeder nachfolgende Keil angrenzend zu dem unmittelbar vorhergehenden Keil und innerhalb einer Rotation des Tiegels nach dem unmittelbar vorhergehenden Keil abgeschieden wird.

**31.** Verfahren gemäß Anspruch 29, wobei jeder nachfolgende Keil angrenzend an den unmittelbar vorhergehenden Keil und folgend mindestens einer Rotation des Tiegels nach dem unmittelbar vorhergehenden Keil abgeschieden wird.

**32.** Verfahren gemäß Anspruch 29, wobei jeder nachfolgende Keil nahezu entgegengesetzt von dem unmittelbar vorhergehenden Keil und angrenzend an den zweitletzten Keil und innerhalb einer Rotation des Tiegels nach dem zweitletzten Keil abgeschieden wird.

**33.** Verfahren gemäß Anspruch 29, wobei jeder nachfolgende Keil nahezu entgegengesetzt von dem unmittelbar vorhergehenden Keil und angrenzend an den zweitletzten Keil und folgend mindestens einer Rotation des Tiegels nach dem zweitletzten Keil abgeschieden wird.

**34.** Verfahren gemäß Anspruch 28, wobei granuläres polykristallines Silizium auf einem Keil vor dem Abscheiden von granulärem polykristallinen Silizium auf dem gesamten ausgesetzten nicht-geschmolzenen polykristallinen Silizium wiederabgeschieden wird.

**35.** Verfahren gemäß Anspruch 1, wobei der Tiegel mit einer Geschwindigkeit *r* rotiert wird, wobei der Tiegel eine innere Wand umfaßt und einen inneren Durchmesser *D* aufweist, und wobei das ausgesetzte nicht-geschmolzene polykristalline Silizium eine Mitte bzw. Zentrum und eine Breite *D* aufweist die dem längsten Abstand zwischen zwei Punkten entlang der Grenzfläche zwischen dem ausgesetzten nicht-geschmolzenen polykristallinen Silizium und der oberen Oberfläche des geschmolzenen Siliziums entspricht, wobei das Verfahren weiter umfaßt:

a. das Bilden der teilweise geschmolzenen Beschickung in dem Tiegel durch Beschicken des nicht-geschmolzenen polykristallinen Siliziums auf eine an geschmolzenem Silizium verarmte Beschickung mit einem Gewicht *w* derart, daß das ausgesetzte nicht-geschmolzene polykristalline Silizium eine Mitte bzw. Zentrum und Breite *d* aufweist, welche dem längsten Abstand zwischen zwei Punkten entlang der Grenzfläche zwischen dem ausgesetzten nicht-geschmolzenen polykristallinen Silizium und der oberen Oberfläche des geschmolzenen Siliziums entspricht,

b. wobei das Beschicken des zusätzlichen polykristallinen Siliziums auf das ausgesetzte nicht-geschmolzene polykristalline Silizium die Breite des ausgesetzten nicht-geschmolzenen polykristallinen Siliziums d beibehält, und

c. wobei die Ein-Periode den Strom von zusätzlichem polykristallinen Silizium mit einer Fließgeschwindigkeit $f$ für eine Zeitdauer $t_{on}$ umfaßt, und die Aus-Periode den Strom von zusätzlichem polykristallinen Silizium durch die Beschickungsvorrichtung für eine Zeitdauer $t_{off}$ unterbricht.

36. Verfahren gemäß Anspruch 35, wobei $w$ etwa 15 Gew.-% bis etwa 40 Gew.-% der Siliziumschmelze beträgt.

37. Verfahren gemäß einem der Ansprüche 35 oder 36, wobei die Grenzfläche zwischen dem nicht-geschmolzenen polykristallinen Siliziums und der oberen Oberfläche des geschmolzenen Siliziums annähernd equidistant von der Mitte des nicht-geschmolzenen polykristallinen Siliziums und annähernd equidistant von der inneren Wand des Tiegels ist.

38. Verfahren gemäß einem der Ansprüche 35 bis 37, wobei das polykristalline Silizium und das zusätzliche polykristalline Silizium, welches in den Tiegel beschickt wird, granuläres polykristallines Silizium sind.

39. Verfahren gemäß einem der Ansprüche 35 bis 38, wobei d von etwa 65% bis etwa 85% von $D$ reicht.

40. Verfahren gemäß einem der Ansprüche 35 bis 39, wobei $r$ von etwa 1 Upm bis etwa 5 Upm reicht.

41. Verfahren gemäß einem der Ansprüche 35 bis 40, wobei $F$ von etwa 5 g/s bis etwa 35 g/s reicht.

42. Verfahren gemäß einem der Ansprüche 35 bis 41, wobei $t_{on}$ von etwa 2 Sekunden bis etwa 10 Sekunden reicht.

43. Verfahren gemäß einem der Ansprüche 35 bis 42, wobei $t_{off}$ mindestens etwa 5 Sekunden beträgt.

44. Verfahren gemäß einem der Ansprüche 35 bis 43, wobei die Beschickungsvorrichtung das granuläre polykristalline Silizium auf einen Anteil des ausgesetzten nicht-geschmolzenen polykristallinen Siliziums richtet.

45. Verfahren gemäß einem der Ansprüche 35 bis 44, wobei der Anteil des ausgesetzten nicht-geschmolzenen polykristallinen Siliziums, worauf das granuläre polykristalline Silizium beschickt wird, ein Keil ist, der sich radial nach außen von etwa der Mitte zu der Grenzfläche zwischen dem nicht-geschmolzenen polykristallinen Silizium und der oberen Oberfläche des geschmolzenen Siliziums erstreckt.

46. Verfahren gemäß Anspruch 45, wobei der Keil einen Keilwinkel aufweist, der weniger als etwa 180° beträgt.

47. Verfahren gemäß Anspruch 45, wobei der Keil einen Keilwinkel aufweist, der von etwa 40° bis etwa 72° reicht.

48. Verfahren gemäß einem der Ansprüche 45 bis 47, wobei jeder Keil auf dem ausgesetzten nicht-geschmolzenen polykristallinen Silizium im wesentlichen nicht mit dem unmittelbar vorhergehenden Keil überlappt.

49. Verfahren gemäß Anspruch 48, wobei granuläres polykristallines Silizium auf dem gesamten ausgesetzten nicht-geschmolzenen polykristallinen Silizium vor dem Wiederabscheiden von granulärem polykristallinen Silizium auf jedwedem Keil abgeschieden wird.

50. Verfahren gemäß Anspruch 49, wobei jeder nachfolgende Keil angrenzend an den unmittelbar vorhergehenden Keil und innerhalb einer Rotation des Tiegels nach dem unmittelbar vorhergehenden Keil abgeschieden wird.

51. Verfahren gemäß Anspruch 49, wobei jeder nachfolgende Keil angrenzend an den unmittelbar vorhergehenden Keil und folgend mindestens einer Rotation des Tiegels nach dem unmittelbar vorhergehenden Keil abgeschieden wird.

52. Verfahren gemäß Anspruch 49, wobei jeder nachfolgende Keil nahezu entgegengesetzt zu dem unmittelbar vorhergehenden Keil und angrenzend an den zweitletzten Keil und innerhalb einer Rotation des Tiegels nach dem zweitletzten Keil abgeschieden wird.

53. Verfahren gemäß Anspruch 49, wobei jeder nachfolgende Keil nahezu entgegengesetzt zu dem unmittelbar vorhergehenden Keil und angrenzend an den zweitletzten Keil und folgend mindestens einer Rotation nach dem zweitletzten Keil abgeschieden wird.

**54.** Verfahren gemäß Anspruch 48, wobei granuläres polykristallines Silizium auf einem Keil vor dem Abscheiden von granulärem polykristallinen Silizium auf dem gesamten ausgesetzten nicht-geschmolzenen polykristallinen Silizium wiederabgeschieden wird.

**55.** Verfahren gemäß einem der Ansprüche 1 bis 54, weiter umfassend das Ziehen eines Einkristall-Siliziumblocks durch das Czochralski-Verfahrens aus der Siliziumschmelze in dem Tiegel.


**Revendications**

**1.** Procédé de préparation d'un produit de fusion de silicium dans un creuset destiné à être utilisé dans la croissance d'un lingot de silicium monocristal par le procédé Czochralski, le procédé comprenant :

a. la formation d'une charge partiellement fondue dans le creuset, la charge partiellement fondue comprenant du silicium fondu et du silicium polycristallin non fondu, le silicium fondu ayant une surface supérieure, le silicium polycristallin non fondu comprenant une partie exposée qui est au-dessus de la surface supérieure du silicium fondu ;
b. la rotation du creuset ;
c. l'alimentation de silicium polycristallin supplémentaire dans le creuset rotatif en fournissant par intermittence le silicium polycristallin supplémentaire sur le silicium polycristallin non fondu exposé, la fourniture par intermittence comprenant une pluralité de périodes actives et de périodes inactives alternant, dans lequel chaque période active comprend l'écoulement du silicium polycristallin supplémentaire au travers d'un dispositif d'alimentation qui dirige l'écoulement du silicium polycristallin supplémentaire sur le silicium polycristallin non fondu de la charge partiellement fondue dans le creuset pour une durée active et chaque période inactive comprend l'interruption de l'écoulement du silicium polycristallin supplémentaire pour la période inactive ; et
d. la fusion du silicium polycristallin non fondu et du silicium polycristallin supplémentaire pour former le produit de fusion de silicium dans le creuset à partir duquel le lingot de silicium monocristal croît.

**2.** Procédé selon la revendication 1, comprenant, en outre, la formation de la charge partiellement fondue dans l'étape a. en chargeant le creuset avec du silicium polycristallin et en chauffant le silicium polycristallin chargé pour former la charge partiellement fondue.

**3.** Procédé selon la revendication 2, dans lequel le creuset comprend une paroi intérieure et a un diamètre intérieur D, dans lequel le creuset chargé est tourné à une vitesse r, dans lequel le silicium polycristallin exposé non fondu présente un centre et une largeur d qui correspond à la distance la plus longue entre deux points le long de l'interface entre le silicium polycristallin non fondu exposé et la surface supérieure du silicium fondu, dans lequel le silicium polycristallin supplémentaire est amené dans le creuset rotatif à un débit d'alimentation F, maintenant ainsi la largeur du silicium polycristallin non fondu exposé d, dans lequel chaque période active comprend l'écoulement du silicium polycristallin supplémentaire à un débit f, pour une durée $t_{act}$, au travers d'un dispositif d'alimentation qui dirige le silicium polycristallin supplémentaire sur le silicium polycristallin non fondu exposé et dans lequel chaque période inactive comprend l'interruption de l'écoulement du silicium polycristallin supplémentaire au travers du dispositif d'alimentation pendant une durée $t_{inact}$.

**4.** Procédé selon la revendication 3, dans lequel l'interface entre le silicium polycristallin non fondu et la surface supérieure du silicium fondu est approximativement équidistante du centre du silicium polycristallin non fondu.

**5.** Procédé selon la revendication 4, dans lequel l'interface entre le silicium polycristallin non fondu et la surface supérieure du silicium fondu est approximativement équidistante de la paroi intérieure du creuset.

**6.** Procédé selon la revendication 5, dans lequel le silicium polycristallin qui est chargé dans le creuset est du silicium polycristallin morceau et le silicium polycristallin supplémentaire amené dans le creuset est du silicium polycristallin granulaire.

**7.** Procédé selon la revendication 6, dans lequel le silicium polycristallin morceau chargé comprend d'environ 40 % à environ 65 % en poids du produit de fusion du silicium.

**8.** Procédé selon l'une quelconque des revendications 6 ou 7, dans lequel d se situe d'environ 65 % à 85 % de D.

9. Procédé selon l'une quelconque des revendications 6 à 8, dans lequel r est d'au moins 1 tour par minute.

10. Procédé selon l'une quelconque des revendications 6 à 8, dans lequel r se situe d'environ 2 tours par minute à environ 3 tours par minute.

11. Procédé selon l'une quelconque des revendications 6 à 10, dans lequel F est d'au moins environ 1 kg/h.

12. Procédé selon l'une quelconque des revendications 6 à 11, dans lequel F se situe d'environ 10 kg/h à environ 20 kg/h.

13. Procédé selon l'une quelconque des revendications 6 à 12, dans lequel f est d'au moins 1 g/s.

14. Procédé selon l'une quelconque des revendications 6 à 13, dans lequel f se situe d'environ 10 g/s à environ 25 g/s.

15. Procédé selon l'une quelconque des revendications 6 à 14, dans lequel $t_{act}$ est d'au moins environ 1 seconde.

16. Procédé selon l'une quelconque des revendications 6 à 15, dans lequel $t_{act}$ se situe d'environ 2 secondes à environ 10 secondes.

17. Procédé selon l'une quelconque des revendications 6 à 16, dans lequel $t_{inact}$ est d'au moins environ 1 seconde.

18. Procédé selon l'une quelconque des revendications 6 à 17, dans lequel $t_{inact}$ est d'au moins environ 5 secondes.

19. Procédé selon l'une quelconque des revendications 6 à 18, dans lequel $t_{inact}$ se situe d'environ 10 secondes à environ 30 secondes.

20. Procédé selon l'une quelconque des revendications 6 à 19, dans lequel l'écoulement du silicium polycristallin granulaire est interrompu pendant la période inactive en utilisant un angle d'un clapet de repos.

21. Procédé selon l'une quelconque des revendications 6 à 20, dans lequel le dispositif d'alimentation dirige le silicium polycristallin granulaire sur une partie du silicium polycristallin non fondu exposé.

22. Procédé selon la revendication 21, dans lequel le dispositif d'alimentation au travers duquel le silicium polycristallin granulaire s'écoule est un tube d'alimentation de type vertical qui est positionné de telle sorte qu'il n'est pas directement au dessus du centre du silicium polycristallin non fondu exposé.

23. Procédé selon la revendication 21, dans lequel le dispositif d'alimentation au travers duquel le silicium polycristallin granulaire s'écoule est un tube d'alimentation de type projection.

24. Procédé selon la revendication 21, dans lequel la partie du silicium polycristallin non fondu exposé sur lequel le silicium polycristallin granulaire est délivré est un coin qui s'étend radialement vers l'extérieur à partir d'environ le centre à l'interface entre le silicium polycristallin non fondu et la surface supérieure du silicium fondu.

25. Procédé selon la revendication 24, dans lequel le coin a un angle de coin qui est d'environ 180°.

26. Procédé selon la revendication 24, dans lequel le coin a un angle de coin qui est inférieur à environ 180°.

27. Procédé selon la revendication 24, dans lequel le coin a un angle de coin qui se situe d'environ 40° à environ 72°.

28. Procédé selon l'une quelconque des revendications 24 à 27, dans lequel chaque coin sur le silicium polycristallin non fondu exposé ne recouvre pas sensiblement le coin immédiatement précédent.

29. Procédé selon la revendication 28, dans lequel le silicium polycristallin granulaire est déposé sur tout le silicium polycristallin non fondu exposé avant le redépôt du silicium polycristallin granulaire sur n'importe quel coin.

30. Procédé selon la revendication 29, dans lequel chaque coin subséquent est déposé près du coin immédiatement précédent et dans une rotation du creuset après le coin immédiatement précédent.

31. Procédé selon la revendication 29, dans lequel chaque coin subséquent est déposé près du coin immédiatement précédent et suivant au moins une rotation du creuset après le coin immédiatement précédent.

**32.** Procédé selon la revendication 29, dans lequel chaque coin subséquent est déposé près de l'opposé du coin immédiatement précédent et près du deuxième coin plus récent et dans une rotation du creuset après le deuxième coin plus récent.

**33.** Procédé selon la revendication 29, dans lequel chaque coin subséquent est déposé près de l'opposé du coin immédiatement précédent et près du deuxième coin plus récent et suivant au moins une rotation du creuset après le deuxième coin plus récent.

**34.** Procédé selon la revendication 28, dans lequel du silicium polycristallin granulaire est redéposé sur un coin avant le dépôt du silicium polycristallin granulaire sur tout le silicium polycristallin non fondu exposé.

**35.** Procédé selon la revendication 1, dans lequel le creuset est tourné à une vitesse r, dans lequel le creuset comprend une paroi intérieure et a un diamètre intérieur D et dans lequel le silicium polycristallin non fondu exposé a un centre et une largeur d qui correspond à la distance la plus longue entre deux points le long de l'interface entre le silicium polycristallin non fondu exposé et la surface supérieure du silicium fondu, dans lequel le procédé comprend en outre :

a. la formation de la charge partiellement fondue dans le creuset en alimentant le silicium polycristallin non fondu sur une charge de silicium fondu épuisé ayant un poids w de sorte que le silicium polycristallin non fondu exposé présente un centre et une largeur d qui correspond à la distance la plus longue entre deux points le long de l'interface entre le silicium polycristallin non fondu exposé et la surface supérieure du silicium fondu ;
b. dans lequel l'alimentation du silicium polycristallin supplémentaire sur le silicium polycristallin non fondu exposé maintient la largeur du silicium polycristallin non fondu exposé d ; et
c. dans lequel la période active comprend l'écoulement du silicium polycristallin supplémentaire à un débit f, pendant une durée $t_{act}$, et la période inactive interrompt l'écoulement du silicium polycristallin supplémentaire au travers du dispositif d'alimentation pendant une durée $t_{inact}$.

**36.** Procédé selon la revendication 35, dans lequel w est d'environ 15 % à environ 40 % en poids du produit fondu de silicium.

**37.** Procédé selon l'une quelconque des revendications 35 ou 36, dans lequel l'interface entre le silicium polycristallin non fondu et la surface supérieure du silicium fondu est approximativement équidistante du centre du silicium polycristallin non fondu et approximativement équidistante de la paroi intérieure du creuset.

**38.** Procédé selon l'une quelconque des revendications 35 à 37, dans lequel le silicium polycristallin et le silicium polycristallin supplémentaire amené dans le creuset sont du silicium polycristallin granulaire.

**39.** Procédé selon l'une quelconque des revendications 35 à 38, dans lequel d se situe d'environ 65 % à environ 85 % de D.

**40.** Procédé selon l'une quelconque des revendications 35 à 39, dans lequel r se situe d'environ 1 tour par minute à environ 5 tours par minute.

**41.** Procédé selon l'une quelconque des revendications 35 à 40, dans lequel f se situe d'environ 5 g/s à environ 35 g/s.

**42.** Procédé selon l'une quelconque des revendications 35 à 41, dans lequel $t_{act}$ se situe d'environ 2 secondes à environ 10 secondes.

**43.** Procédé selon l'une quelconque des revendications 35 à 42, dans lequel $t_{inact}$ est d'au moins environ 5 secondes.

**44.** Procédé selon l'une quelconque des revendications 35 à 43, dans lequel le dispositif d'alimentation dirige le silicium polycristallin granulaire sur une partie du silicium polycristallin non fondu exposé.

**45.** Procédé selon l'une quelconque des revendications 35 à 44, dans lequel la partie du silicium polycristallin non fondu exposé sur laquelle le silicium polycristallin granulaire est délivré est un coin qui s'étend radialement à l'extérieur à partir d'environ le centre à l'interface entre le silicium polycristallin non fondu et la surface supérieure du silicium fondu.

**46.** Procédé selon la revendication 45, dans lequel le coin a un angle de coin qui est inférieur à environ 180°.

47. Procédé selon la revendication 45, dans lequel le coin a un angle de coin qui se situe d'environ 40° à environ 72°.

48. Procédé selon l'une quelconque des revendications 45 à 47, dans lequel chaque coin sur le silicium polycristallin non fondu exposé ne recouvre pas sensiblement le coin immédiatement précédent.

49. Procédé selon la revendication 48, dans lequel le silicium polycristallin granulaire est déposé sur tout le silicium polycristallin non fondu exposé avant le redépôt du silicium polycristallin granulaire sur n'importe quel coin.

50. Procédé selon la revendication 49, dans lequel chaque coin subséquent est déposé près du coin immédiatement précédent et dans une rotation du creuset après le coin immédiatement précédent.

51. Procédé selon la revendication 49, dans lequel chaque coin subséquent est déposé près du coin immédiatement précédent et suivant au moins une rotation du creuset après le coin immédiatement précédent.

52. Procédé selon la revendication 49, dans lequel chaque coin subséquent est déposé près de l'opposé du coin immédiatement précédent et près du deuxième coin plus récent et dans une rotation du creuset après le deuxième coin plus récent.

53. Procédé selon la revendication 49, dans lequel chaque coin subséquent est déposé près de l'opposé du coin immédiatement précédent et près du deuxième coin plus récent et suivant au moins une rotation du creuset après le deuxième coin plus récent.

54. Procédé selon la revendication 48, dans lequel du silicium polycristallin granulaire est redéposé sur un coin avant le dépôt du silicium polycristallin granulaire sur tout le silicium polycristallin non fondu exposé.

55. Procédé selon l'une quelconque des revendications 1 à 54, comprenant, en outre, la croissance d'un lingot de silicium monocristal par le procédé Czochralski à partir du produit de fusion de silicium dans le creuset.

FIG. 1

FIG. 2

FIG. 3

FIG. 4

EP 1 446 517 B1

FIG. 5

# FIG. 6

# FIG. 7

# FIG. 8A

# FIG. 8B

# FIG. 8C

# FIG. 9A

# FIG. 9B

# FIG. 9C

# FIG. 10

## REFERENCES CITED IN THE DESCRIPTION

**Patent documents cited in the description**

- JP 50011788 U
- US 5037503 A
- US 5588993 A
- US 5059410 A, Boone

**Non-patent literature cited in the description**

- **F. SHIMURA.** Semiconductor Silicon Crystal Technology. Academic Press, 1989, 116-121
- **F. SHIMURA.** Semiconductor Silicon Crystal Technology. Academic Press, 1989, 175-83